# EUROPEAN PATENT APPLICATION

(11) **EP 4 815 697 A1**
(43) Date of publication of application: **30.09.2026**
(21) Application number: 26163910.8
(22) Date of filing: 11.03.2026
(51) Int. Cl.: H10K 59/65, H10K 59/88, H10K 50/11

(54) **DISPLAY MODULE AND ELECTRONIC DEVICE INCLUDING THE SAME**

(30) Priority: 25.03.2025 KR 20250038078
(71) Applicant: Samsung Display Co., Ltd., Yongin-si, Gyeonggi-do 17113 (KR)
(72) Inventor: KIM, Donghoo, Yongin-si (KR); KIM, Jinmin, Yongin-si (KR); CHOI, Kiho, Yongin-si (KR); KIM, Jungmin, Yongin-si (KR); KIM, Hwiseong, Yongin-si (KR); PARK, Jihun, Yongin-si (KR); CHO, Yong, Yongin-si (KR); CHO, Eunji, Yongin-si (KR); CHOI, Sangjin, Yongin-si (KR)
(74) Representative: Marks & Clerk LLP

(57) **Abstract**

A display module includes a display region (DA) and a hole region (HA), which includes a transmission region (TA) and a margin region (MA). The display module includes a base substrate (BA), a light emitting device layer (EDL), and an encapsulation substrate (ES). A first light-emitting region (EML-R), a second light-emitting region (EML-G), and a third light-emitting region (EML-B) are defined in the display region, and a first region, a second region, and a third region are defined in the margin region. The light emitting device layer includes a first sacrificial layer (SL-R) in the first region and including a first material, and a first dummy layer (DM-R), a second sacrificial layer (SL-G) in the second region and including a second material, and a second dummy layer (DM-G), and a third sacrificial layer (SL-B) in the third region and including the first material or the second material, and a third dummy layer (DM-B).

## Description

### BACKGROUND

Some example embodiments of the present disclosure relate to a display module including a hole region and an electronic device including the same.

Multimedia electronic devices such as televisions, mobile phones, tablets, navigation systems, and gaming consoles may include a display device, which is used to provide an image to a user through its display screen. The display device may include a display module generating the image.

The electronic device may include an electronic module, in addition to the display module. The electronic module may also include a camera, an infrared light sensing sensor, or a proximity sensor.

### SUMMARY

Some example embodiments of the inventive concepts provide a display module including a hole region with improved optical transmittance.

Some example embodiments of the inventive concepts provide an electronic device including a camera module, which is disposed below the hole region of the display module and is configured to have a relatively low failure rate.

According to some example embodiments of the inventive concepts, a display module includes a display region and a hole region adjacent to the display region. The hole region includes a transmission region and a margin region, and the margin region least partially surrounds the transmission region. The display module further includes a base substrate, the display region and the hole region overlapping the base substrate, a light emitting device layer on the base substrate, wherein the display region and the margin region overlap the light emitting device layer and the transmission region does not overlap the light emitting device layer, and an encapsulation substrate on the light emitting device layer, wherein the display region and the hole region overlap the encapsulation substrate. The display region includes a first light-emitting region configured to emit a red light, a second light-emitting region configured to emit a green light, and a third light-emitting region configured to emit a blue light. The light emitting device layer includes a first light emitting layer in the first light-emitting region, a second light emitting layer in the second light-emitting region, and a third light emitting layer in the third light-emitting region. The margin region defines a first region, a second region adjacent to the first region, and a third region adjacent to the second region. The light emitting device layer includes a first sacrificial layer in the first region and including a first material, and a first dummy layer on the first sacrificial layer, a second sacrificial layer in the second region and including a second material, and a second dummy layer on the second sacrificial layer, and a third sacrificial layer in the third region and including the first material or the second material, and a third dummy layer on the third sacrificial layer.

According to some example embodiments, the first dummy layer may include a same material as the first light emitting layer, the second dummy layer may include a same material as the second light emitting layer, and the third dummy layer may include a same material as the third light emitting layer.

According to some example embodiments, the light emitting device layer may further include a first electrode, wherein the display region may overlap the first electrode and the hole region may not overlap the first electrode, and a hole transfer region. The display region and the margin region may overlap the hole transfer region and the transmission region may not overlap the hole transfer region. The hole transfer region may be directly on the first electrode in the display region and may be directly on the base substrate in the margin region.

According to some example embodiments, the light emitting device layer may further include an electron transfer region, wherein the electron transfer region may overlap the display region and the margin region, and a second electrode on the electron transfer region.

According to some example embodiments, each of the first material and the second material may include an organic material that may be configured to form into a film by a thermal evaporation process and configured to be removed using a laser beam.

According to some example embodiments, the third sacrificial layer may include the first material, and a thickness of the third sacrificial layer may be equal to a thickness of the first sacrificial layer.

According to some example embodiments, the third sacrificial layer may include the second material, and a thickness of the third sacrificial layer may be equal to a thickness of the second sacrificial layer.

According to some example embodiments, the light emitting device layer may further include an additional sacrificial layer (e.g., between the base substrate and the second sacrificial layer in the second region), and wherein the additional sacrificial layer may include the first material.

According to some example embodiments, a thickness of the first sacrificial layer may be equal to a thickness of the third sacrificial layer, and a thickness of the additional sacrificial layer may be equal to the thickness of the first sacrificial layer and the thickness of the third sacrificial layer.

According to some example embodiments, the first sacrificial layer, the additional sacrificial layer, and the third sacrificial layer may be a single layer.

According to some example embodiments, the light emitting device layer further includes a pixel definition layer, wherein the display region may overlap the pixel definition layer and the hole region may not overlap the pixel definition layer, and an opening defined by the pixel definition layer, the opening may correspond to one of the first light-emitting region, the second light-emitting region, and the third light-emitting region of the display region.

According to some example embodiments, the display region may at least partially surround the hole region.

According to some example embodiments of the inventive concepts, an electronic device includes an active region configured to display an image and a sensing region at least partially surrounded by the active region. The electronic device further includes a display module including a display region corresponding to the active region and a hole region corresponding to the sensing region, and an electronic module configured to receive or configured to output a signal through the hole region, wherein the hole region at least partially overlaps the electronic module. The hole region includes a transmission region and a margin region at least partially surrounding the transmission region. The display module includes a base substrate, wherein the display region and the hole region overlap the base substrate, a light emitting device layer on the base substrate, wherein the display region and the margin region overlap the light emitting device layer, and the transmission region does not overlap the light emitting device layer, and an encapsulation substrate on the light emitting device layer, wherein the display region and the hole region overlap the encapsulation substrate. The display region includes a first light-emitting region configured to emit a red light, a second light-emitting region configured to emit a green light, and a third light-emitting region configured to emit a blue light. The light emitting device layer includes a first light emitting layer in the first light-emitting region, a second light emitting layer in the second light-emitting region, and a third light emitting layer in the third light-emitting region. The margin region may include a first region, a second region adjacent to the first region, and a third region adjacent to the second region. The light emitting device layer includes a first sacrificial layer in the first region and including a first material, and a first dummy layer on the first sacrificial layer, a second sacrificial layer in the second region and including a second material, and a second dummy layer on the second sacrificial layer, and a third sacrificial layer in the third region and including the first material or the second material, and a third dummy layer on the third sacrificial layer.

According to some example embodiments, the first dummy layer may include a same material as the first light emitting layer, the second dummy layer may include a same material as the second light emitting layer, and the third dummy layer may include a same material as the third light emitting layer.

According to some example embodiments, the light emitting device layer may include a first electrode, wherein the display region may overlap the first electrode and the hole region may not overlap the first electrode, and a hole transfer region, wherein the display region and the margin region may overlap the hole transfer region and the transmission region may not overlap the hole transfer region. The hole transfer region may be directly on the first electrode in the display region and may be directly on the base substrate in the margin region.

According to some example embodiments, each of the first material and the second material may include an organic material that is configured to form into a film by a thermal evaporation process and configured to be removed using a laser beam.

According to some example embodiments, the light emitting device layer may further include an additional sacrificial layer between the base substrate and the second sacrificial layer in the second region, and wherein the additional sacrificial layer may include the first material.

According to some example embodiments, the electronic module may be a camera module.

According to some example embodiments, the electronic device may further include at least one of a processor, a memory, or a power module.

According to some example embodiments, the electronic device may be a television, a computer monitor, an outdoor advertisement display, a personal computer, a laptop computer, a personal digital terminal, an in-vehicle device, a game console, a smartphone, a tablet, a smart watch, or a camera.

At least some of the above and other features of the invention are set out in the claims.

### BRIEF DESCRIPTION OF THE DRAWINGS

FIG. 1 is a block diagram illustrating an electronic device according to some example embodiments of the inventive concepts.
FIG. 2 is a schematic diagram illustrating different electronic devices according to some example embodiments of the inventive concepts.
FIG. 3 is a perspective view illustrating an assembled structure of an electronic device according to some example embodiments of the inventive concepts.
FIG. 4 is an exploded perspective view illustrating an electronic device according to some example embodiments of the inventive concepts.
FIG. 5 is a sectional view illustrating a display device according to some example embodiments of the inventive concepts.
FIG. 6 is an enlarged plan view illustrating a display module according to some example embodiments of the inventive concepts.
FIG. 7 is an enlarged sectional view illustrating a display module according to some example embodiments of the inventive concepts.
FIGS. 8 and 9 are enlarged plan views, each illustrating a display module according to some example embodiments of the inventive concepts.
FIGS. 10, 11, and 12 are enlarged sectional views, each illustrating a display module according to some example embodiments of the inventive concepts.

### DETAILED DESCRIPTION

In the present specification, when a component (or region, layer, portion, and so on) is described as being "on," "connected to," or "coupled with" another component, it means that the component may be directly placed on, connected to, or coupled with the other component, or that a third component may be interposed between them.

The same reference numerals refer to the same elements. Also, in the drawings, the thickness, proportions, and dimensions of elements may be exaggerated for the sake of clarity and ease of explanation. The term "and/or" includes any and all combinations of the associated elements.

Terms such as "first" and "second" may be used to describe various components but should not be interpreted as limiting. These terms are used solely to distinguish one component, part, region, layer, or portion from another. For example, without departing from the scope of the inventive concept, a "first" component, part, region, layer, or portion may be referred to as a "second" one, and likewise, a "second" one may be referred to as a "first" one. The singular forms also include the plural forms unless the context clearly indicates otherwise.

Furthermore, terms such as "below," "under," "above," and "over" are used to describe relative positions of elements as illustrated in the drawings. These terms are relative and are used with reference to the orientations shown in the drawings.

The terms "include" or "have" (and variations thereof) are intended to specify the presence of features, numbers, steps, operations, components, parts, or combinations thereof described in the specification, and are not intended to preclude the presence or addition of one or more other features, numbers, steps, operations, components, parts, or combinations thereof.

As used herein, expressions such as "one of," "one or more of," "any one of," "at least one of," and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Unless otherwise defined, all terms used in the present specification (including technical and scientific terms) have the same meaning as commonly understood by one of ordinary skill in the relevant art. Terms defined in commonly used dictionaries should be interpreted in accordance with their meanings in the context of the relevant technology, and should not be interpreted in an overly idealized or formal sense unless explicitly defined herein.

Hereinafter, some example embodiments according to the inventive concepts will be described with reference to the accompanying drawings.

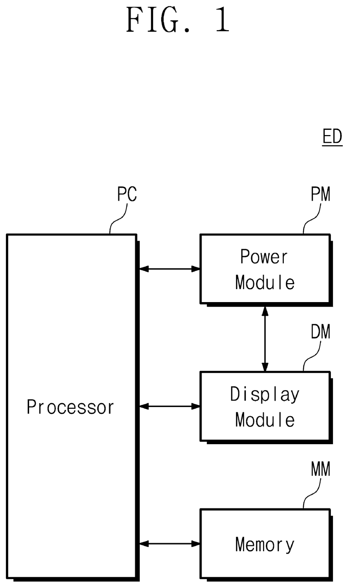

FIG. 1 is a block diagram illustrating an electronic device according to some example embodiments of the inventive concepts.

Referring to FIG. 1, an electronic device ED according to some example embodiments of the inventive concepts may include a display module DM, a processor PC, a memory MM, and/or a power module PM.

The processor PC may include at least one of a central processing unit (CPU), an application processor (AP), a graphics processing unit (GPU), a communication processor (CP), an image signal processor (ISP), or a controller.

The memory MM may be configured to store data used to operate the processor PC and/or the display module DM. When an application stored in the memory MM is executed by the processor PC, image data signals and/or input control signals may be transferred to the display module DM, and the display module DM may process the transferred signals and output an image through a display screen.

The power module PM may include a power supplying module (e.g., a power adapter or a battery unit) and a power conversion module, which is configured to transform the power supplied from the power supplying module and produce or generate power required for the operation of the electronic device ED.

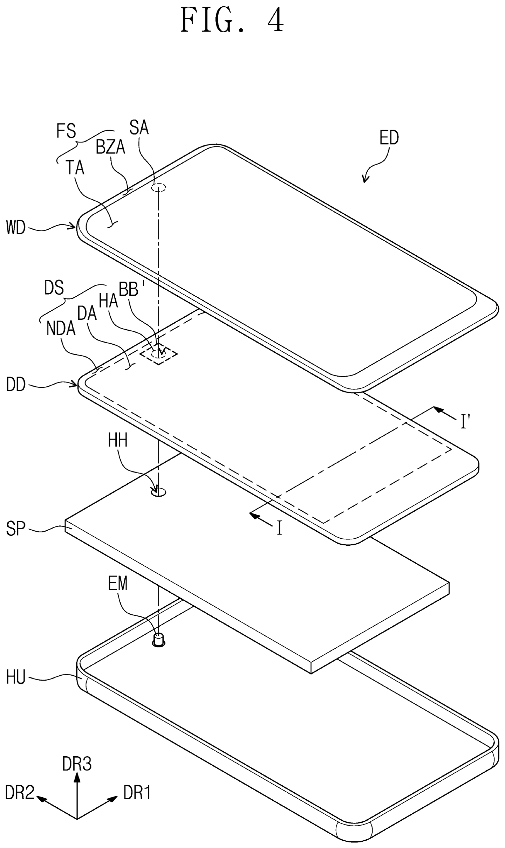

At least one of the components of the electronic device ED may be included in a display device DD (FIG. 4) according to some example embodiments of the inventive concepts. In addition, a portion of each module, which is included as a functional part of the module, may be included in the display device, and other potions may be provided as a separate component different from the display device. For example, the display device DD (FIG. 4) may include the display module DM, while the processor PC, the memory MM, and the power module PM may be provided as components of the electronic device ED rather than of the display device.

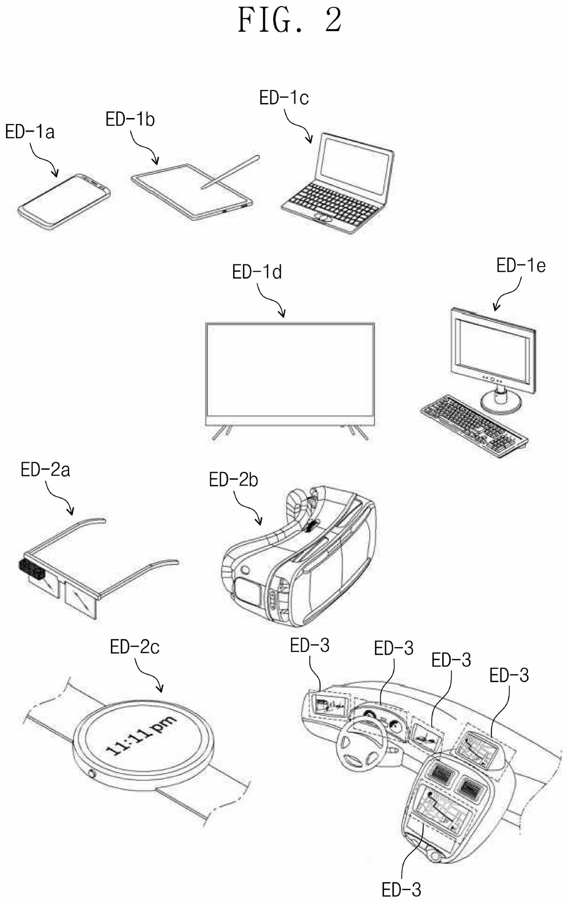

FIG. 2 is a schematic diagram illustrating different electronic devices according to some example embodiments of the inventive concepts.

Referring to FIG. 2, the display module DM according to some example embodiments of the inventive concepts may be applied to or used in different electronic devices including image-displaying electronic devices (e.g., a smartphone ED-1a, a tablet PC ED-1b, a laptop computer ED-1c, a television ED-1d, or a computer monitor ED-1e), wearable electronic devices (e.g., smart glasses ED-2a, a head-mounted display ED-2b, or a smart watch ED-2c), and/or a vehicle electronic device (or an in-vehicle device) ED-3 (e.g., instrument cluster, a center fascia display, a dashboard-mounted center information display (CID), or a room mirror display).

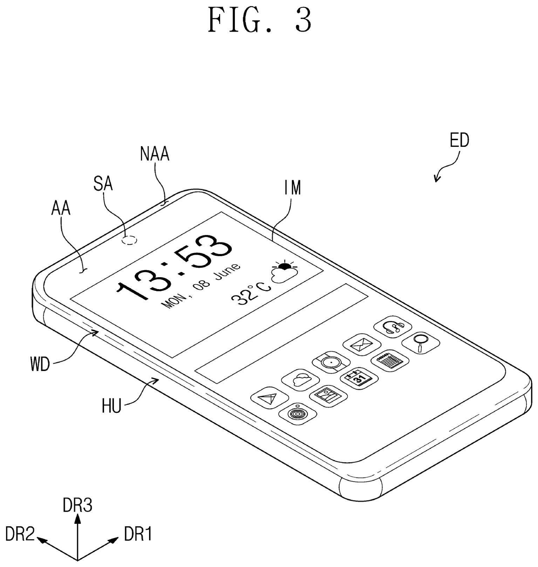

FIG. 3 is a perspective view illustrating an assembled structure of an electronic device according to some example embodiments of the inventive concepts. FIG. 4 is an exploded perspective view illustrating an electronic device according to some example embodiments of the inventive concepts.

In some example embodiments, the electronic device ED may be a device that may be activated by an electrical signal applied thereto. For example, the electronic device ED may be a television, a personal digital terminal, an outdoor advertisement display, a personal computer, a camera, a monitor, a cellular phone, a tablet, an in-vehicle navigation device, a gaming console, or a wearable device, but example embodiments are not limited to these examples. As an example and for the purposes of discussion, FIG. 3 illustrates the electronic device ED as a cellular phone.

In some example embodiments, the electronic device ED may include an active region AA and a peripheral region NAA. The active region AA of the electronic device ED may display an image IM. The image IM may be a video image or a still image. In FIG. 3, a clock widget and a plurality of application icons are displayed as parts of the image IM. The active region AA of the electronic device ED may correspond to a display region DA of a display device DD, and the peripheral region NAA may correspond to a non-display region NDA of the display device DD. In some example embodiments, the active region AA of the electronic device ED may correspond to a transmission region TA of a window WD, and the peripheral region NAA may correspond to a bezel region BZA of the window WD.

The electronic device ED may display the image IM in a third direction axis DR3 on a display surface, which is parallel to a first direction axis DR1 and a second direction axis DR2. Stated otherwise, the display surface may lie in a plane defined by the first direction axis DR1 and the second direction axis DR2. The display surface, on which the image IM is displayed, may correspond to the top or front surface of the electronic device ED and may correspond to a top surface FS of the window WD. In addition, the electronic device ED may have a three-dimensional structure having a specific (or given or desired) thickness in the third direction axis DR3 perpendicular to the first and second direction axes DR1 and DR2.

In the present disclosure, each of components, members, units, and parts may have a top or front surface and a bottom or rear surface defined based on a direction, in which the image IM is displayed. The top and bottom surfaces may be opposite each other in the third direction axis DR3, and a direction normal to each of the top and bottom surfaces may be parallel to the third direction axis DR3. Directions indicated by the first, second, and third direction axes DR1, DR2, and DR3 may be a relative concept, and in some example embodiments, they may be used to indicate other directions. Hereinafter, first, second, and third directions may be directions indicated by the first, second, and third direction axes DR1, DR2, and DR3, respectively, and will be referenced with the same numerals.

The active region AA may be parallel to the first direction axis DR1 and the second direction axis DR2 and may have a tetragonal shape (e.g., rectangle). Stated otherwise, the active region AA may lie in a plane (also referred to as DR1-DR2 plane) defined by the first direction axis DR1 and the second direction axis DR2. However, example embodiments are not limited thereto, and the active region AA may have different shapes depending on application and/or design.

The peripheral region NAA may be a light-blocking region that is placed outside or along the periphery of the active region AA and may at least partially enclose or surround the active region AA. In some example embodiments, the peripheral region NAA may be provided on a side surface (e.g., a surface in the DR2-DR3 plane or a surface in the DR1-DR3 plane) of the electronic device ED, instead of or in addition to the front surface of the electronic device ED. In some example embodiments, the peripheral region NAA may be omitted.

In some example embodiments, a sensing region SA may be defined or otherwise located adjacent to the active region AA of the electronic device ED. The sensing region SA may be enclosed or otherwise surrounded by the active region AA. Alternatively, the sensing region SA may be provided in a side or edge portion of the active region AA. FIG. 3 illustrates, as an example, one sensing region SA, but the number of the sensing regions SA is not limited thereto.

An electronic module EM may be disposed in a region overlapped with the sensing region SA. The electronic module EM may be configured to receive external signals input through the sensing region SA or output signals to the outside through the sensing region SA.

In some example embodiments, the electronic device ED may be rigid. Alternatively, the electronic device ED may be flexible. In the disclosure, "flexible" as used herein may indicate that the display device DD can bend or fold to radii of curvature ranging from a few angstroms to several centimeters. For example, the electronic device ED may be a curved display device, a rollable display device, a slidable display device, or a foldable display device.

In some example embodiments, the electronic device ED may include the display device DD and the electronic module EM disposed below the display device DD. In some example embodiments, the electronic device ED may further include the window WD disposed on the display device DD. In some example embodiments, the electronic device ED may further include a supporting member SP and/or a housing HU placed below the display device DD. In the electronic device ED shown in FIGS. 3 and 4, the window WD and the housing HU may combine to cooperatively form the exterior of the electronic device ED. A penetration hole HH, which overlaps the electronic module EM, may be defined in the supporting member SP. In some example embodiments, the penetration hole HH may be a through hole, and may be sized or shaped or otherwise configured to receive or accommodate the electronic module EM.

The window WD may include the top surface FS exposed to the outside. In the top surface FS of the window WD, the transmission region TA may be an optically transparent region. The transmission region TA may have a shape corresponding to the display region DA of the display device DD. For example, the transmission region TA may overlap the front surface of the display region DA or at least a portion thereof. An image displayed on the display region DA of the display device DD may be recognized or viewed by a user through the transmission region TA.

The bezel region BZA of the window WD may be provided adjacent to the transmission region TA and may at least partially enclose the transmission region TA. The bezel region BZA may cover or otherwise overlap the non-display region NDA of the display device DD and may prevent (or limit) the non-display region NDA from being recognized or viewed by a user. The sensing region SA may be defined in the transmission region TA of the window WD. The sensing region SA of the window WD may be defined as the sensing region SA of the electronic device ED.

In the electronic device ED according to some example embodiments of the inventive concepts, the electronic module EM may be an electronic component configured to output or receive an optical signal. For example, the electronic module EM may be a camera module configured to capture an image of an external object. In some example embodiments, the electronic module EM may be a sensor module (e.g., a proximity sensor or an infrared light-emitting sensor).

In the electronic device ED according to some example embodiments of the inventive concepts, the display device DD may be disposed on the electronic module EM. The display device DD may include the display region DA and the non-display region NDA which are adjacent to each other. In other words, a top surface DS of the display device DD may include the display region DA and the non-display region NDA. The top surface DS of the display device DD may be referred to as a display surface. In some example embodiments, the display region DA may be activated by an electrical signal applied thereto.

The non-display region NDA may be adjacent to the display region DA. The non-display region NDA may at least partially enclose or surround the display region DA. A driving circuit or driving lines, which are used to drive the display region DA, or various signal lines, pads, or electronic devices, which are used to deliver electrical signals to the display region DA, may be disposed in the non-display region NDA.

In the display device DD according to some example embodiments of the inventive concepts, a hole region HA may be defined adjacent to the display region DA. The hole region HA may be at least partially enclosed or otherwise surrounded by the display region DA. Alternatively, the hole region HA may be provided in a side or edge portion of the display region DA. FIG. 4 illustrates, as an example, one hole region HA, but the number of the hole regions HA is not limited thereto. The hole region HA may correspond to the sensing region SA of the electronic device ED. The hole region HA may overlap the electronic module EM.

The supporting member SP disposed below the display device DD may include a cushion layer and/or a metal supporting layer. The penetration hole HH may be defined in the supporting member SP. The penetration hole HH may be defined to correspond to the hole region HA of the display device DD. The penetration hole HH may be a portion corresponding to the sensing region SA of the electronic device ED.

The penetration hole HH may overlap the electronic module EM. At least a portion of the electronic module EM may be inserted or otherwise received in the penetration hole HH.

The window WD and the housing HU may combine to cooperatively form the exterior of the electronic device ED. The window WD and the housing HU may combine to cooperatively form or define an internal space, in which components such as the display device DD can be placed or arranged. The display device DD, the supporting member SP, the electronic module EM, and so forth may be contained or arranged in the internal space.

The housing HU may include a material with relatively high rigidity. For example, the housing HU may include a frame and/or a plate, which is formed of or include at least one of glass, plastic materials, metallic materials, or combinations thereof. The housing HU may absorb shocks or stresses applied from external sources and may prevent or limit or impede foreign matter (or debris or contaminants) and/or moisture from entering the electronic device ED, thereby protecting the display device DD placed in the housing HU.

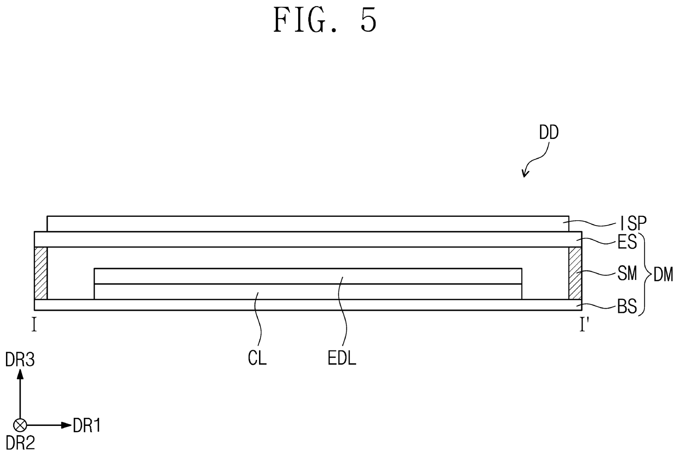

FIG. 5 is a sectional view illustrating a display module according to some example embodiments of the inventive concepts.

FIG. 5 is a sectional view of the display device DD including the display module DM according to some example embodiments of the inventive concepts, taken along line I-I' of FIG. 4.

The display device DD may include the display module DM configured to generate an image. In some example embodiments, the display device DD may further include an input sensor ISP configured to sense an external input.

Referring to FIG. 5, the input sensor ISP may be directly disposed on the display module DM. The input sensor ISP may be formed consecutively on a base surface provided by the display module DM during the fabrication process of the display module DM. The input sensor ISP and the display module DM may be combined to form a single component, without using an additional adhesive layer.

In some example embodiments, the display device DD may further include an adhesive layer disposed between the input sensor ISP and the display module DM. The input sensor ISP may be attached to the display module DM through an adhesive layer. For example, the input sensor ISP may be provided as a touch panel, which is fabricated through a separate process different from the fabrication process of the display module DM, and the input sensor ISP may be attached to the display module DM through an adhesive layer disposed on a top surface of the display module DM. The adhesive layer may include a transparent adhesive (e.g., an optically clear adhesive film (OCA), an optically clear adhesive resin (OCR), or a pressure sensitive adhesive film (PSA)). However, example embodiments are not limited to these examples.

Example embodiments are not limited to the stacking structure and order of the display device DD shown in FIG. 5. For example, the display device DD may further include an optical member disposed on the display module DM.

The display module DM may include a base substrate BS, a circuit device layer CL, a light emitting device layer EDL, an encapsulation substrate ES, and a sealant SM.

The base substrate BS may include a base surface, on which the circuit device layer CL is disposed. The base substrate BS may be a rigid substrate or a flexible substrate, which can be bent, folded, or rolled. The base substrate BS may include a plastic substrate, a glass substrate, a metal substrate, or a composite substrate formed of organic/inorganic materials. The base substrate BS may have a multi-layered structure. For example, the base substrate BS may include an inorganic layer, a synthetic resin layer, or a composite material layer.

The circuit device layer CL may be disposed on the base substrate BS. The circuit device layer CL may include at least one insulating layer, at least one semiconductor pattern, and at least one conductive pattern. The insulating layer, the semiconductor layer, and the conductive layer may be formed through a coating or deposition process and then may be patterned through one or more photolithography processes to form an insulating layer, a semiconductor pattern, and a conductive pattern constituting the circuit device layer CL. The insulating layer, the semiconductor pattern, and the conductive pattern, which are included in the circuit device layer CL, may form driving devices (e.g., transistors), signal lines, and pads constituting the circuit device layer CL.

The light emitting device layer EDL may be disposed on the circuit device layer CL. The light emitting device layer EDL may include light-emitting devices. The light-emitting devices of the light emitting device layer EDL may be electrically connected to the driving devices of the circuit device layer CL to generate light and display an image in response to signals provided to the driving devices.

The encapsulation substrate ES may be disposed on the light emitting device layer EDL. The encapsulation substrate ES may include a plastic substrate, a glass substrate, a metal substrate, or a composite substrate formed of organic/inorganic composite materials. The encapsulation substrate ES may be spaced apart from the light emitting device layer EDL in the third direction DR3, thereby forming a gap. In some example embodiments, the display module DM may further include a filling layer that is provided to fill the gap. The filling layer may include a desiccant or resin material.

The sealant SM may be disposed between the base substrate BS and the encapsulation substrate ES, and may be disposed on the side surfaces of the filling layer. The sealant SM may bond the encapsulation substrate ES to the base substrate BS. The sealant SM may include an organic adhesive material, a frit, or the like.

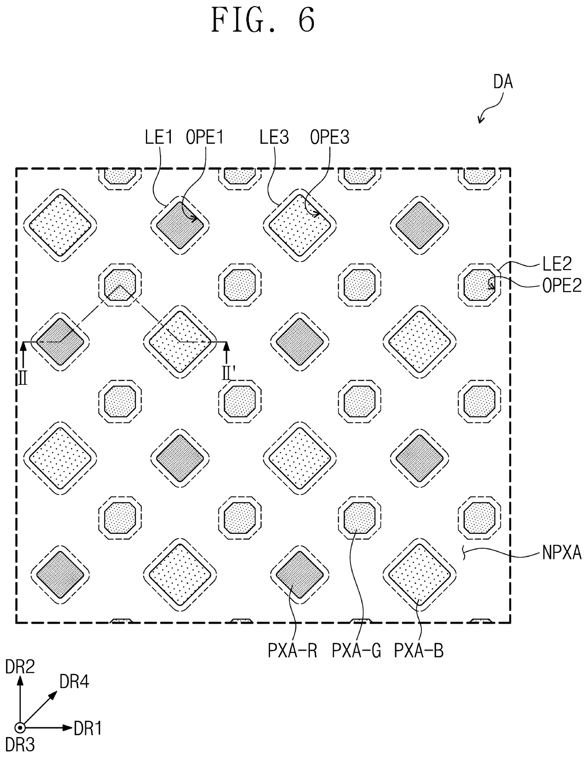

FIG. 6 is an enlarged plan view illustrating a display module according to some example embodiments of the inventive concepts.

FIG. 6 is an enlarged plan view illustrating a portion of the display region DA according to some example embodiments of the inventive concepts. FIG. 6 is an enlarged, example top plan view (e.g., in a plane extending in the first and second directions DR1 and DR2) of the display region DA of the display module DM (shown in FIG. 4).

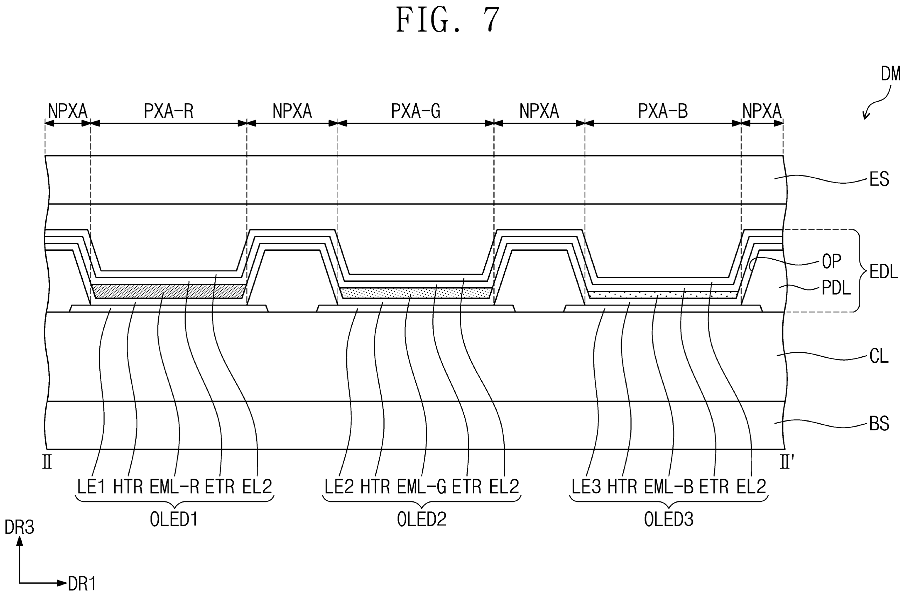

Referring to FIG. 6, the display region DA may include first, second, and third light-emitting regions PXA-R, PXA-G, and PXA-B and a non-light-emitting region NPXA enclosing or surrounding the first, second, and third light-emitting regions PXA-R, PXA-G, and PXA-B. The first, second, and third light-emitting regions PXA-R, PXA-G, and PXA-B may correspond to regions, through which light generated by light-emitting devices OLED1, OLED2, and OLED3 (shown in FIG. 7) are emitted.

FIG. 6 illustrates first electrodes LE1, LE2, and LE3, which constitute the light-emitting devices OLED1, OLED2, and OLED3 (shown in FIG. 7), for convenience in illustration. The first electrodes LE1, LE2, LE3 may be referred to as lower electrodes. The first, second, and third light-emitting regions PXA-R, PXA-G, and PXA-B may be classified based on the colors of light emitted from the display module DM (shown in FIG. 4) to the outside.

The first, second, and third light-emitting regions PXA-R, PXA-G, and PXA-B may be configured to emit first, second, and third color light whose colors are different from each other. For example, the first color light may be a red light, the second color light may be a green light, and the third color light may be a blue light. However, the first, second, and third color light are not limited to the above examples.

Each of the first, second, and third light-emitting regions PXA-R, PXA-G, and PXA-B may be defined as a region of a top surface of a corresponding one of the lower electrodes LE1, LE2, and LE3 exposed through a corresponding one of light-emitting openings OPE1, OPE2, and OPE3. The light-emitting openings OPE1, OPE2, and OPE3 may be defined by a pixel definition layer PDL (shown in FIG. 7) that covers a portion of the lower electrodes LE1, LE2, and LE3, as described below.

The first light-emitting region PXA-R may be defined as a region of the top surface of the first lower electrode LE1 exposed through a first light-emitting opening OPE1. The second light-emitting region PXA-G may be defined as a region of the top surface of the second lower electrode LE2 exposed through a second light-emitting opening OPE2. The third light-emitting region PXA-B may be defined as a region of the top surface of the third lower electrode LE3 exposed through a third light-emitting opening OPE3.

The non-light-emitting region NPXA may set the boundary between the first, second, and third light-emitting regions PXA-R, PXA-G, and PXA-B and may be used to prevent or limit a color-mixing issue between the first, second, and third light-emitting regions PXA-R, PXA-G, and PXA-B.

Each first, second, and third light-emitting region PXA-R, PXA-G, and PXA-B may have a desired size and shape. A plurality of the first, second, and third light-emitting regions PXA-R, PXA-G, and PXA-B may be arranged in a desired pattern in the display region DA.

For example, referring to FIG. 6, the first light-emitting regions PXA-R and the third light-emitting regions PXA-B may be alternately arranged in the first direction DR1 to form a 'first group'. In addition, the second light-emitting regions PXA-G may be arranged in the first direction DR1 to form a 'second group'. As illustrated, each second light-emitting region PXA-G may be arranged between adjacent first light-emitting region PXA-R and third light-emitting region PXA-B. Each of the first and second groups may include a plurality of groups, and in this case, the first and second groups may be alternately arranged in the second direction DR2.

Each of the second light-emitting regions PXA-G may be spaced apart from a corresponding one of the first or third light-emitting regions PXA-R or PXA-B in a fourth direction DR4. The fourth direction DR4 may be defined as a direction that is parallel to or in a plane defined by the first and second directions DR1 and DR2 and is oblique to both the first and second directions DR1 and DR2.

As shown in FIG. 6, the first, second, and third light-emitting regions PXA-R, PXA-G, and PXA-B may be arranged in a PENTILE^{™} configuration. However, FIG. 6 illustrates merely an example of the arrangement of the first, second, and third light-emitting regions PXA-R, PXA-G, and PXA-B, but the inventive concepts are not limited to this example. For example, the first, second, and third light-emitting regions PXA-R, PXA-G, and PXA-B may be arranged in a stripe shape or a Diamond Pixel^{™} configuration.

Each of the first, second, and third light-emitting regions PXA-R, PXA-G, and PXA-B may have different shapes, when viewed in a plan view. For example, each of the first, second, and third light-emitting regions PXA-R, PXA-G, and PXA-B may have a polygonal, circular, or elliptical shape. FIG. 6 illustrates an example, in which the first and third light-emitting regions PXA-B and PXA-R have a tetragonal (or diamond-like) shape and the second light-emitting region PXA-G has an octagonal shape in a plan view.

When viewed in a plan view, the first, second, and third light-emitting regions PXA-R, PXA-G, and PXA-B may have the same shape or may have, at least partially, different shapes from each other. FIG. 6 illustrates an example, in which the first and third light-emitting regions PXA-R and PXA-B have the same shape and the second light-emitting region PXA-G has a different shape from each of the first and third light-emitting regions PXA-R and PXA-B.

At least one of the first, second, or third light-emitting regions PXA-R, PXA-G, and PXA-B may have a different planar area from the others. In detail, the area of the first light-emitting region PXA-R emitting the red light may be larger than the area of the second light-emitting region PXA-G emitting the green light and may be smaller than the area of the third light-emitting region PXA-B emitting the blue light. However, example embodiments are not limited to the above difference in area between the first, second, and third light-emitting regions PXA-R, PXA-G, and PXA-B according to depending on the colors of the emitted lights, and the areas of the first, second, and third light-emitting regions PXA-R, PXA-G, and PXA-B may be changed depending on the application and/or design of the display module DM (shown in FIG. 4). For example, the first, second, and third light-emitting regions PXA-R, PXA-G, and PXA-B may have the same area, when viewed in a plan view.

According to some example embodiments of the inventive concepts, one or more of the planar shape, area, and arrangement of the first, second, and third light-emitting regions PXA-R, PXA-G, and PXA-B of the display module DM (shown in FIG. 4) may be changed depending on the colors of the emitted light and the size and structure of the display module DM (shown in FIG. 4), and are not limited to the example embodiments illustrated in FIG. 6.

The lower electrodes LE1, LE2, and LE3 may be coupled to pixel driving circuits in the circuit device layer CL (shown in FIG. 5) through coupling contact holes. Each of the coupling contact holes may be spaced apart from the light-emitting regions PXA-R, PXA-G, and PXA-B defined in the lower electrodes LE1, LE2, and LE3. Alternatively, the coupling contact holes may be overlapped with at least a portion of the light-emitting regions PXA-R, PXA-G, and PXA-B defined in the lower electrodes LE1, LE2, and LE3, respectively.

FIG. 7 is an enlarged cross-sectional view of the display module DM according to some example embodiments of the inventive concepts, taken along line II-II' of FIG. 6.

The display module DM may include the base substrate BS, the circuit device layer CL, and the light emitting device layer EDL, which are provided on the base substrate BS. The base substrate BS, the circuit device layer CL, and the encapsulation substrate ES may be configured to have features same as or similar in some respects to those in the example embodiments of FIG. 5, and a description thereof is omitted herein for the sake of brevity.

The light emitting device layer EDL may include the pixel definition layer PDL, and light-emitting devices OLED1, OLED2, and OLED3. The light-emitting devices OLED1, OLED2, and OLED3 may be disposed between patterns (or openings) of the pixel definition layer PDL. The encapsulation substrate ES may be disposed on the light-emitting devices OLED1, OLED2, and OLED3, and the pixel definition layer PDL.

The light-emitting device OLED1 may include the first electrode LE1, a hole transfer region HTR, a light emitting layer EML-R, an electron transfer region ETR, and a second electrode EL2. The light-emitting device OLED2 may include the first electrode LE2, a hole transfer region HTR, a light emitting layer EML-G, an electron transfer region ETR, and a second electrode EL2. The light-emitting device OLED3 may include the first electrode LE3, a hole transfer region HTR, a light emitting layer EML-B, an electron transfer region ETR, and a second electrode EL2. As illustrated, each of the light-emitting devices OLED1, OLED2, and OLED3 may be stacked structures in which the corresponding first electrodes LE1, LE2, LE3, the hole transfer region HTR, the light emitting layers EML-R, EML-G, EML-B, the electron transfer region ETR, and the second electrode EL2 are stacked on each other in the third direction axis DR3. Also, as illustrated, the hole transfer region HTR, the electron transfer region ETR, and the second electrode EL2 are conformally formed on the pixel definition layer PDL and the first electrodes LE1, LE2, LE3.

FIG. 7 illustrates an example in which the light emitting layers EML-R, EML-G, and EML-B of the light-emitting devices OLED1, OLED2, and OLED3 are placed within openings OP in the pixel definition layer PDL that are at least partially defined by the pixel definition layer PDL and the corresponding first electrodes LE1, LE2, LE3. In some example embodiments, the openings OP may correspond to the light-emitting openings OPE1, OPE2, and OPE3 in FIG. 6. The hole transfer region HTR, the electron transfer region ETR, and the second electrode EL2 are provided as a common layer throughout the light-emitting devices OLED1, OLED2, and OLED3. However, example embodiments are not limited thereto, and in some example embodiments, the hole transfer region HTR and the electron transfer region ETR may be provided in the form of patterns within individual openings OP and may be isolated from the other hole transfer region HTR and electron transfer region ETR formed in corresponding openings. In some example embodiments, the hole transfer region HTR, the light emitting layers EML-R, EML-G, and EML-B, and the electron transfer region ETR of the light-emitting device OLED1, OLED2, or OLED3 may be provided as isolated patterns formed by an inkjet printing method. In some example embodiments, each second electrode EL2 may be provided in the form of a pattern within individual openings OP and may be isolated from the other second electrodes EL2 in the corresponding openings OP. In some example embodiments, the patterns including the second electrode EL2 may be formed by an inkjet printing method.

Referring to FIGS. 6 and 7, the display device DD may include the non-light-emitting region NPXA and the light-emitting regions PXA-R, PXA-G, and PXA-B. Each of the light-emitting regions PXA-R, PXA-G, and PXA-B may be a region from which light generated in the light-emitting devices OLED1, OLED2, and OLED3 is emitted. The light-emitting regions PXA-R, PXA-G, and PXA-B may be spaced apart from each other, when viewed in a plan view (FIG. 6).

The light-emitting regions PXA-R, PXA-G, and PXA-B may be regions that are distinguished or otherwise defined by the pixel definition layer PDL. The non-light-emitting regions NPXA may be placed between adjacent light-emitting regions PXA-R, PXA-G, and PXA-B and may correspond to the pixel definition layer PDL. In the specification, each of the light-emitting regions PXA-R, PXA-G, and PXA-B may correspond to a single pixel. The pixel definition layer PDL may be provided to distinguish or otherwise separate the light-emitting devices OLED1, OLED2, and OLED3. The light emitting layers EML-R, EML-G, and EML-B of the light-emitting devices OLED1, OLED2, and OLED3 may be placed (or arranged or formed) within the opening OP defined in the pixel definition layer PDL and may be separated from each other.

The light-emitting regions PXA-R, PXA-G, and PXA-B may be classified into a plurality of groups, depending on colors of light generated from the light-emitting devices OLED1, OLED2, and OLED3. For example, the display module DM may include a red light-emitting region PXA-R, a green light-emitting region PXA-G, and a blue light-emitting region PXA-B that are distinguished from each other. The light-emitting devices OLED1, OLED2, and OLED3 may be configured to emit (e.g., selectively emit) light in different wavelength regions. For example, the display module DM may include a first light-emitting device OLED1 emitting red light, a second light-emitting device OLED2 emitting green light, and a third light-emitting device OLED3 emitting blue light. The red light-emitting region PXA-R, the green light-emitting region PXA-G, and the blue light-emitting region PXA-B of the display module DM may correspond to the first light-emitting device OLED1, the second light-emitting device OLED2, and the third light-emitting device OLED3, respectively.

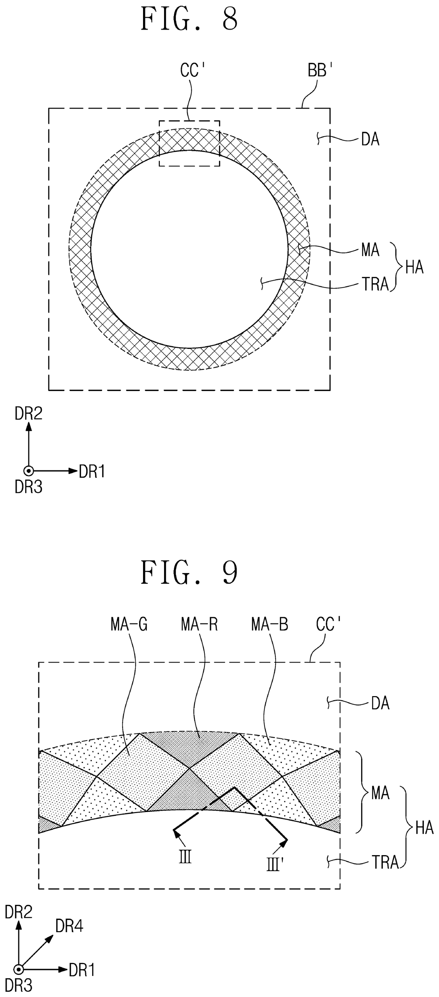

FIGS. 8 and 9 are enlarged plan views, each illustrating a display module according to some example embodiments of the inventive concepts.

FIG. 8 is an enlarged plan view illustrating a portion BB' of FIG. 4. FIG. 9 is an enlarged plan view illustrating a portion CC' of FIG. 8.

Referring to FIG. 8, the hole region HA may be disposed adjacent to the display region DA. The hole region HA may be enclosed or surrounded or otherwise defined by the display region DA. However, example embodiments are not limited to this configuration of the hole region HA. For example, the hole region HA may be placed in (or in contact with) a side or edge of the display region DA and near the non-display region NDA (or, alternatively, in the non-display region NDA) (shown in FIG. 4), and may thus be partially defined or partially surrounded by the display region DA.

The electronic module EM (shown in FIG. 4) placed below the hole region HA may receive an external input through the hole region HA or may output signals through the hole region HA. In some example embodiments, the electronic module EM may be a camera module.

The hole region HA may have a circular shape, when viewed in a plan view. However, the shape of the hole region HA in the plan view is not limited thereto. For example, the hole region HA may have an elliptical shape or a polygonal shape, when viewed in a plan view. In some example embodiments, the display module DM (shown in FIG. 4) may include a plurality of hole regions HA, and the hole regions HA may have the same or different shapes, when viewed in a plan view.

The hole region HA may include a margin region MA and a transmission region TRA. The margin region MA may be a region that is not removed by a laser beam in a process of forming the transmission region TRA in the display module DM (shown in FIG. 4) and is located at a boundary between the display region DA and the transmission region TRA. The margin region MA may be disposed between the display region DA and the transmission region TRA. The margin region MA may enclose or at least partially surround the transmission region TRA.

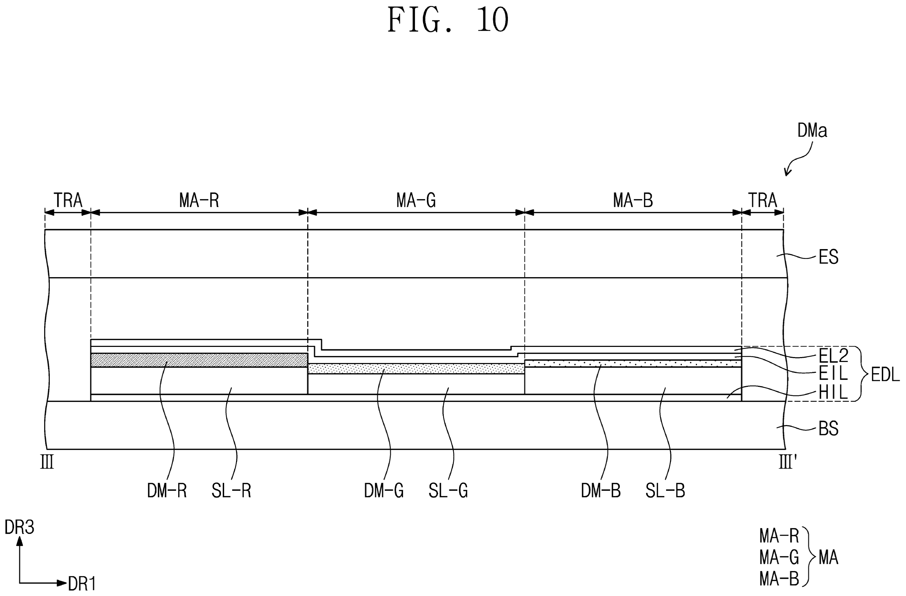

Referring to FIG. 9, the margin region MA may include a first region MA-R, a second region MA-G, and a third region MA-B. The first region MA-R may be defined as a region on which a first dummy layer DM-R (shown in FIG. 10) is disposed, the second region MA-G may be defined as a region on which a second dummy layer DM-G (shown in FIG. 10) is disposed, and the third region MA-B may be defined as a region on which a third dummy layer DM-B (shown in FIG. 10) is disposed.

The first region MA-R, the second region MA-G, and the third region MA-B of the margin region MA may be placed in the same manner as the first light-emitting region PXA-R, the second light-emitting region PXA-G, and the third light-emitting region PXA-B of the display region DA (shown in FIG. 6). However, the first, second, and third light-emitting regions PXA-R, PXA-G, and PXA-B of the display region DA (shown in FIG. 6) may be spaced apart from each other by the pixel definition layer PDL (shown in FIG. 7), and the first, second, and third regions MA-R, MA-G, and MA-B of the margin region MA may not be spaced apart from each other by the pixel definition layer PDL (shown in FIG. 7) and may be in contact with each other.

The margin region MA may include a plurality of the first, second, and third regions MA-R, MA-G, and MA-B, which are repeatedly arranged in a specific (or given or desired) shape within the margin region MA. For example, a plurality of first regions MA-R and a plurality of third regions MA-B may be alternately arranged in the first direction DR1 to form a first group. In addition, the second regions MA-G may be arranged in the first direction DR1 to form a second group. Each of the first group and second group may include a plurality of groups, depending on the area of the margin region, and in some example embodiments, the first and second groups may be alternately arranged in the second direction DR2. Each of the second regions MA-G may be placed in the fourth direction DR4 relative to the first region MA-R or the third region MA-B. FIG. 9 illustrates an example in which the margin region MA includes a portion of two first groups and one second group, but example embodiments of the inventive concepts are not limited thereto. For example, the structure of the margin region MA may be changed depending on the area of the margin region MA or an opening pattern of a deposition mask used in a process of forming the first, second, and third dummy layers DM-R, DM-G, and DM-B (shown in FIG. 10).

Each of the first, second, and third dummy layers DM-R, DM-G, and DM-B (shown in FIG. 10) defining the first, second, and third regions MA-R, MA-G, and MA-B of the margin region MA may be formed in the same process step or operation as a corresponding one of the first, second, and third light emitting layer EML-R, EML-G, and EML-B of the display region DA (shown in FIG. 7), as will be described below. Thus, as described above, the arrangement and configuration of the first, second, and third regions MA-R, MA-G, and MA-B may be the same as or similar in some respects to those of the first, second, and third light-emitting regions PXA-R, PXA-G, and PXA-B (shown in FIG. 6) corresponding to the first, second, and third light emitting layer (EML-R, EML-G, EML-G) (shown in FIG. 7), except that they are not spaced apart from each other. In addition, at least one of the first, second, or third regions MA-R, MA-G, and MA-B may have an area different from the others in a plan view, similar to the first, second, and third light-emitting regions PXA-R, PXA-G, and PXA-B (shown in FIG. 6).

FIGS. 10, 11, and 12 are sectional views, each illustrating a display module according to some example embodiments of the inventive concepts.

FIGS. 10, 11, and 12 are enlarged sectional views of the display modules taken along line III-III' of FIG. 9.

Referring to FIGS. 10, 11, and 12, the base substrate BS and the encapsulation substrate ES may be overlapped with the display region DA (shown in FIG. 6) as well as the hole region HA. The base substrate BS and the encapsulation substrate ES may be overlapped with both the margin region MA and the transmission region TRA of the hole region HA. In each display module DMa, DMb, or DMc, the base substrate BS and the encapsulation substrate ES may be placed in the transmission region TRA, and thus, the transmission region TRA may exhibit improved or excellent optical transmittance. Accordingly, the operations for inputting external signals to and outputting signals from the electronic module EM (shown in FIG. 4), which is placed below the transmission region TRA, may be performed efficiently or smoothly and with reduced interference.

Alternatively, each of the display modules DMa, DMb, and DMc may further include a filling layer provided between the base substrate BS and the encapsulation substrate ES and in the transmission region TRA. The filling layer may include a desiccant or resin material having relatively higher optical transmittance.

In the hole region HA, the margin region MA may overlap the light emitting device layer EDL, and the transmission region TRA may not overlap (or, may be offset from) the light emitting device layer EDL. In the margin region MA, the light emitting device layer EDL may include a hole injection layer HIL disposed on the base substrate BS, sacrificial layers SL-R, SL-G, and SL-B disposed on the hole injection layer HIL, dummy layers DM-R, DM-G, and DM-B disposed on the corresponding sacrificial layers SL-R, SL-G, and SL-B, an electron injection layer EIL disposed on the dummy layers DM-R, DM-G, and DM-B, and the second electrode EL2 disposed on the electron injection layer EIL.

In the margin region MA, the hole injection layer HIL may be directly disposed on the base substrate BS.

Referring to FIG. 10, in the display module DMa, a first sacrificial layer SL-R may be disposed on the hole injection layer HIL of the first region MA-R. The first sacrificial layer SL-R may be directly disposed on the hole injection layer HIL of the first region MA-R. A second sacrificial layer SL-G may be disposed on the hole injection layer HIL of the second region MA-G. The second sacrificial layer SL-G may be directly disposed on the hole injection layer HIL of the second region MA-G. A third sacrificial layer SL-B may be disposed on the hole injection layer HIL of the third region MA-B. The third sacrificial layer SL-B may be directly disposed on the hole injection layer HIL of the third region MA-B.

The first sacrificial layer SL-R may include a first material, the second sacrificial layer SL-G may include a second material, and the third sacrificial layer SL-B may include the first material. A thickness of the first sacrificial layer SL-R may be two times (or about two times) that of the first light emitting layer EML-R (shown in FIG. 7). For example, the thickness of the first sacrificial layer SL-R may range from 700 Å (or about 700 Å) to 800 Å (or about 800 Å). A thickness of the second sacrificial layer SL-G may be two times (or about two times) that of the second light emitting layer EML-G (shown in FIG. 7). A thickness of the third sacrificial layer SL-B may be equal to the thickness of the first sacrificial layer SL-R.

The first material and the second material may be different from each other. The first material and the second material may be materials forming the sacrificial layers and may be organic materials that can be formed into a film by a thermal evaporation process. The first, second, and third sacrificial layers SL-R, SL-G, and SL-B may be formed by changing a mask and a deposition source material in a process of forming the first, second, and third light emitting layers EML-R, EML-G, and EML-B (shown in FIG. 7) of the display region DA (shown in FIG. 6).

The first material and the second material may be organic materials that react with and are removed by a laser beam in a laser irradiation process. The laser beam may be irradiated onto the hole region HA in the process of forming the transmission region TRA. Here, the first material and the second material in the first, second, and third sacrificial layers SL-R, SL-G, and SL-B may be removed by the reaction with the laser beam. When the first, second, and third sacrificial layers SL-R, SL-G, and SL-B are detached by the reaction with the laser beam, a portion of the hole injection layer HIL, which is in contact with the first, second, and third sacrificial layers SL-R, SL-G, and SL-B, may also be detached and removed. The irradiation of the laser beam may be performed, for example, in instances of a process error, and in this case, there may be a region, to which the laser beam is not irradiated. Thus, the first, second, and third sacrificial layers SL-R, SL-G, and SL-B may be left in a portion of the margin region MA, which is not irradiated by the laser beam.

According to some example embodiments of the inventive concepts, since the display modules DMa, DMb, and DMc include the sacrificial layers SL-R, SL-G, and SL-B, which include the first material or the second material on the hole injection layer HIL, it may be possible to obtain improved or excellent laser processing properties with minimal or reduced additional processing. Accordingly, it may be possible to remove the materials for the light emitting device layer EDL from the transmission region TRA with relatively reduced residue issue and thereby improve the optical transmittance of the transmission region TRA. As a result, the electronic module EM (shown in FIG. 4) (e.g., a camera module overlapped with the transmission region TRA) may perform signal transmission and reception operations efficiently.

The first dummy layer DM-R may be disposed on the first sacrificial layer SL-R. The first dummy layer DM-R may include the same material as the first light emitting layer EML-R (shown in FIG. 7). The first dummy layer DM-R may be formed concurrently during a deposition process of forming the first light emitting layer EML-R (shown in FIG. 7). The second dummy layer DM-G may be disposed on the second sacrificial layer SL-G. The second dummy layer DM-G may include the same material as the second light emitting layer EML-G (shown in FIG. 7). The second dummy layer DM-G may be formed concurrently during a deposition process of forming the second light emitting layer EML-G (shown in FIG. 7). The third dummy layer DM-B may be disposed on the third sacrificial layer SL-B. The third dummy layer DM-B may include the same material as the third light emitting layer EML-B (shown in FIG. 7). The third dummy layer DM-B may be formed concurrently during a deposition process of forming the third light emitting layer EML-B (shown in FIG. 7). The pixel definition layer PDL (shown in FIG. 7) defining the first, second, and third light-emitting regions PXA-R, PXA-G, and PXA-B (shown in FIG. 7) may not be disposed in the margin region MA, and the first, second, and third dummy layers DM-R, DM-G, and DM-B may be formed to be in contact with each other, without separation between them.

The electron injection layer EIL and the second electrode EL2 may be disposed on the first, second, and third dummy layers DM-R, DM-G, and DM-B.

According to some example embodiments of the inventive concepts, a method of fabricating the display module DMa may include preparing a preliminary display module, forming the transmission region TRA, and bonding the encapsulation substrate ES to the preliminary display module having the transmission region TRA.

The preliminary display module may include the display region DA and the hole region HA, and in the preparation of the preliminary display module, the base substrate BS, the hole injection layer HIL, the sacrificial layers SL-R, SL-G, and SL-B, the dummy layers DM-R, DM-G, and DM-B, the electron injection layer EIL, and the second electrode EL2 may be formed on the hole region HA as illustrated in the margin region MA of FIG. 10. As described above, each of the first, second, and third dummy layers DM-R, DM-G, and DM-B of the margin region MA may be formed simultaneously when each of the first, second, and third light emitting layers EML-R, EML-G, and EML-B of the display region DA (shown in FIG. 6) is formed.

In the formation of the transmission region TRA, the preliminary display module may be placed in such a way that the base substrate BS faces upward and the hole injection layer HIL faces downward. The hole region HA of the preliminary display module may be irradiated with a laser beam. Here, the irradiation of the laser beam may be executed in the direction from the base substrate BS toward the sacrificial layers SL-R, SL-G, and SL-B. The sacrificial layers SL-R, SL-G, and SL-B may be detached downward (or away from the hole injection layer HIL) by the laser beam. In this case, a portion of the hole injection layer HIL, which is in contact with the sacrificial layers SL-R, SL-G, and SL-B detached by the irradiation of the laser beam, may also be detached and removed. In addition, portions of the dummy layers DM-R, DM-G, and DM-B, the electron injection layer EIL, and the second electrode EL2, which are located below the detached sacrificial layers SL-R, SL-G, and SL-B, may also be detached and removed.

In the operation of bonding the encapsulation substrate ES, the base substrate BS and the encapsulation substrate ES may be bonded to each other by the sealant SM (shown in FIG. 5). The sealant SM (shown in FIG. 5) may include an organic adhesive agent or frit.

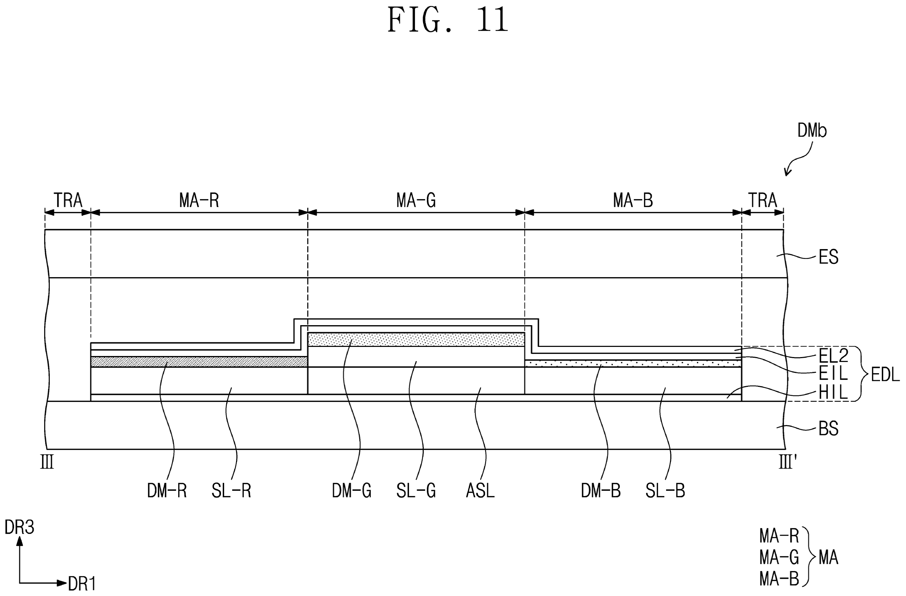

The display module DMb may be same as or similar in some respects to the display module DMa of FIG. 10, and therefore may be best understood with reference thereto where like numerals indicate like elements not described again in detail. Referring to FIG. 11, in the display module DMb, the first sacrificial layer SL-R may be disposed on the hole injection layer HIL of the first region MA-R. The first sacrificial layer SL-R may be directly disposed on the hole injection layer HIL of the first region MA-R. The second sacrificial layer SL-G may be disposed on the hole injection layer HIL of the second region MA-G. An additional sacrificial layer ASL may be disposed on the hole injection layer HIL of the second region MA-G. The additional sacrificial layer ASL may be directly disposed on the hole injection layer HIL of the second region MA-G. The second sacrificial layer SL-G may be directly disposed on the additional sacrificial layer ASL. The third sacrificial layer SL-B may be disposed on the hole injection layer HIL of the third region MA-B. The third sacrificial layer SL-B may be directly disposed on the hole injection layer HIL of the third region MA-B.

The first sacrificial layer SL-R may include a first material, the second sacrificial layer SL-G may include a second material, and the third sacrificial layer SL-B may include the first material. The additional sacrificial layer ASL may include the first material. A thickness of the third sacrificial layer SL-B and a thickness of the additional sacrificial layer ASL may be the same as that of the first sacrificial layer SL-R. As a result, the upper surfaces (in the third direction DR3) of the first sacrificial layer SL-R, the additional sacrificial layer ASL, and the third sacrificial layer SL-B may be coplanar. In some example embodiments, the first sacrificial layer SL-R, the additional sacrificial layer ASL, and the third sacrificial layer SL-B may be a single layer that is extended throughout the first, second, and third regions MA-R, MA-G, and MA-B.

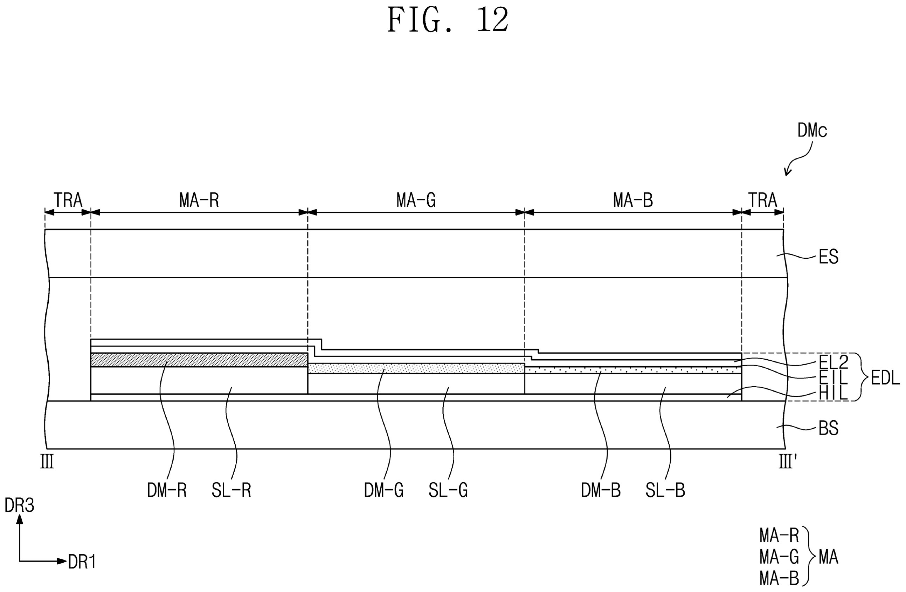

The display module DMc may be same as or similar in some respects to the display module DMa of FIG. 10, and therefore may be best understood with reference thereto where like numerals indicate like elements not described again in detail. Referring to FIG. 12, in the display module DMc, the first sacrificial layer SL-R may be disposed on the hole injection layer HIL of the first region MA-R. The first sacrificial layer SL-R may be directly disposed on the hole injection layer HIL of the first region MA-R. The second sacrificial layer SL-G may be disposed on the hole injection layer HIL of the second region MA-G. The second sacrificial layer SL-G may be directly disposed on the hole injection layer HIL of the second region MA-G. The third sacrificial layer SL-B may be disposed on the hole injection layer HIL of the third region MA-B. The third sacrificial layer SL-B may be directly disposed on the hole injection layer HIL of the third region MA-B.

The first sacrificial layer SL-R may include a first material, the second sacrificial layer SL-G may include a second material, and the third sacrificial layer SL-B may include the second material. A thickness of the third sacrificial layer SL-B may be equal to a thickness of the second sacrificial layer SL-G.

According to some example embodiments of the inventive concepts, the display module includes a sacrificial layer, which is provided in a hole region, and may have improved or excellent laser processing properties. Thus, the optical transmittance of the hole region may be increased.

In addition, the electronic device according to some example embodiments of the inventive concepts includes the display module including the hole region with the improved optical transmittance, and thus, it may be possible to reduce failure rate of the camera module, which is disposed below the hole region.

As described herein, any devices, systems, modules, portions, units, controllers, circuits, and/or portions thereof according to any of the example embodiments, and/or any portions thereof (including, without limitation, the display module DM, the processor PC, the memory MM, the power module PM, the smartphone ED-1a, the tablet PC ED-1b, the laptop computer ED-1c, the television ED-1d, or the computer monitor ED-1e, the smart glasses ED-2a, the head-mounted display ED-2b, the smart watch ED-2c, and/or the vehicle electronic device ED-3, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

While several embodiments have been provided in the present disclosure, it should be understood that the disclosed systems and methods might be embodied in many other specific forms without departing from the scope of the present disclosure, as defined by the following claims. The present examples are to be considered as illustrative and not restrictive, and the intention is not to be limited to the details given herein. For example, the various elements or components may be combined or integrated in another system or certain features may be omitted, or not implemented.

## Claims

1. A display module (DM), comprising:
a display region (DA); and
a hole region (HA) adjacent to the display region (DA), the hole region including a transmission region (TA) and a margin region (MA), and the margin region (MA) at least partially surrounding the transmission region (TA);
a base substrate (BS), the display region (DA) and the hole region (HA) overlapping the base substrate (BS);
a light emitting device layer (EDL) on the base substrate (BS), wherein the display region (DA) and the margin region (MA) overlap the light emitting device layer (EDL) and the transmission region (TA) does not overlap the light emitting device layer (EDL); and
an encapsulation substrate (ES) on the light emitting device layer (EDL), wherein the display region (DA) and the hole region (HA) overlap the encapsulation substrate (ES),
wherein the display region (DA) includes a first light-emitting region (PXA-R) configured to emit a red light, a second light-emitting region (PXA-G) configured to emit a green light, and a third light-emitting region (PXA-B) configured to emit a blue light,
wherein the light emitting device layer (EDL) comprises,
a first light emitting layer (EML-R) in the first light-emitting region (PXA-R);
a second light emitting layer (EML-G) in the second light-emitting region (PXA-G); and
a third light emitting layer (EML-B) in the third light-emitting region (PXA-B),
wherein the margin region (MA) defines a first region (MA-R), a second region (MA-G) adjacent to the first region (MA-R), and a third region (MA-B) adjacent to the second region (MA-G),
wherein the light emitting device layer (EDL) comprises,
a first sacrificial layer (SL-R) in the first region (MA-R) and including a first material, and a first dummy layer (DM-R) on the first sacrificial layer (SL-R),
a second sacrificial layer (SL-G) in the second region (MA-G) and including a second material, and a second dummy layer (DM-G) on the second sacrificial layer (SL-G), and
a third sacrificial layer (SL-B) in the third region (MA-B) and including the first material or the second material, and a third dummy layer (DM-B) on the third sacrificial layer (SL-B).

2. The display module (DM) of claim 1, wherein the first dummy layer (DM-R) comprises a same material as the first light emitting layer (EML-R),
the second dummy layer (DM-G) comprises the same material as the second light emitting layer (EML-G), and
the third dummy layer (DM-B) comprises the same material as the third light emitting layer (EML-B).

3. The display module (DM) of claim 1 or claim 2, wherein the light emitting device layer (EDL) further comprises:
a first electrode (LE1, LE2, LE3), wherein the display region (DA) overlaps the first electrode (LE1, LE2, LE3) and the hole region (HA) does not overlap the first electrode (LE1, LE2, LE3); and
a hole transfer region (HTR), wherein the display region (DA) and the margin region (MA) overlap the hole transfer region (HTR) and the transmission region (TA) does not overlap the hole transfer region (HTR),
wherein the hole transfer region (HTR) is directly on the first electrode (LE1, LE2, LE3) in the display region (DA) and is directly on the base substrate (BS) in the margin region (MA).

4. The display module (DM) of any one of claims 1 to 3, wherein the light emitting device layer (EDL) further comprises:
an electron transfer region (ETR), wherein the electron transfer region (ETR) overlaps the display region (DA) and the margin region (MA); and
a second electrode (EL2) on the electron transfer region (ETR).

5. The display module (DM) of any one of claims 1 to 4, wherein each of the first material and the second material comprises an organic material that is configured to form into a film by a thermal evaporation process and configured to be removed using a laser beam.

6. The display module (DM) of any one of claims 1 to 5, wherein the third sacrificial layer (SL-B) comprises the first material, and
a thickness of the third sacrificial layer (SL-B) is equal to a thickness of the first sacrificial layer (SL-R).

7. The display module (DM) of any one of claims 1 to 5, wherein the third sacrificial layer (SL-B) comprises the second material, and
a thickness of the third sacrificial layer (SL-B) is equal to a thickness of the second sacrificial layer (SL-G).

8. The display module (DM) of any one of claims 1 to 5, wherein the light emitting device layer (EDL) further comprises an additional sacrificial layer (ASL) between the base substrate (BS) and the second sacrificial layer (SL-G) in the second region (MA-G), and wherein the additional sacrificial layer (ASL) includes the first material.

9. The display module (DM) of claim 8, wherein a thickness of the first sacrificial layer (SL-R) is equal to a thickness of the third sacrificial layer (SL-B), and
a thickness of the additional sacrificial layer (ASL) is equal to the thickness of the first sacrificial layer (SL-R) and the thickness of the third sacrificial layer (SL-B).

10. The display module (DM) of claim 8 or claim 9, wherein the first sacrificial layer (SL-R), the additional sacrificial layer (ASL), and the third sacrificial layer (SL-B) are a single layer.

11. The display module (DM) of any one of claims 1 to 10, wherein the light emitting device layer (EDL) further comprises a pixel definition layer (PDL), wherein the display region (DA) overlaps the pixel definition layer (PDL) and the hole region (HA) does not overlap the pixel definition layer (PDL), and
an opening (OP) defined by the pixel definition layer (PDL), the opening (OP) corresponding to one of the first light-emitting region (PXA-R), the second light-emitting region (PXA-G), and the third light-emitting region (PXA-B) of the display region (DA).

12. The display module (DM) of any one of claims 1 to 11, wherein the display region (DA) at least partially surrounds the hole region (HA).

13. An electronic device (ED), comprising:
an active region (AA) configured to display an image (IM);
a sensing region (SA) at least partially surrounded by the active region (AA);
a display module (DM) including a display region (DA) corresponding to the active region (AA) and a hole region (HA) corresponding to the sensing region (SA); and
an electronic module (EM) configured to receive or configured to output a signal through the hole region (HA), the hole region (HA) at least partially overlapping the electronic module (ME),
wherein the hole region (HA) comprises a transmission region (TA) and a margin region (MA) at least partially surrounding the transmission region (TA),
wherein the display module (DM) comprises,
a base substrate (BS), wherein the display region (DA) and the hole region (HA) overlap the base substrate (BS);
a light emitting device layer (EDL) on the base substrate (BS),
wherein the display region (DA) and the margin region (MA) overlap the light emitting device layer (EDL), and the transmission region (TA) does not overlap the light emitting device layer (EDL); and
an encapsulation substrate (ES) on the light emitting device layer (EDL), wherein the display region (DA) and the hole region (HA) overlap the encapsulation substrate (ES),
wherein the display region (DA) includes a first light-emitting region (PXA-R) configured to emit a red light, a second light-emitting region (PXA-G) configured to emit a green light, and a third light-emitting region (PXA-B) configured to emit a blue light,
wherein the light emitting device layer (EDL) comprises,
a first light emitting layer (EML-R) in the first light-emitting region (PXA-R);
a second light emitting layer (EML-G) in the second light-emitting region (PXA-G); and
a third light emitting layer (EML-B) in the third light-emitting region (PXA-B),
wherein the margin region (MA) includes a first region (MA-R), a second region (MA-G) adjacent to the first region (MA-R), and a third region (MA-B) adjacent to the second region (MA-G),
wherein the light emitting device layer (EDL) comprises:
a first sacrificial layer (SL-R) in the first region (MA-R) and including a first material, and a first dummy layer (DM-R) on the first sacrificial layer (SL-R),
a second sacrificial layer (SL-G) in the second region (MA-G) and including a second material, and a second dummy layer (DM-G) on the second sacrificial layer (SL-G), and
a third sacrificial layer (SL-B) in the third region (MA-B) and including the first material or the second material, and a third dummy layer (DM-B) on the third sacrificial layer (SL-B).

14. The electronic device (ED) of claim 13, wherein the first dummy layer (DM-R) comprises a same material as the first light emitting layer (EML-R),
the second dummy layer (DM-G) comprises the same material as the second light emitting layer (EML-G), and
the third dummy layer (DM-B) comprises the same material as the third light emitting layer (EML-B).

15. The electronic device (ED) of claim 13 or claim 14, wherein the light emitting device layer (EDL) comprises:
a first electrode(LE1, LE2, LE3), wherein the display region overlaps the first electrode(LE1, LE2, LE3) and the hole region does not overlap the first electrode(LE1, LE2, LE3); and
a hole transfer region (HTR), wherein the display region (DA) and the margin region (MA) overlap the hole transfer region (HTR) and the transmission region (TA) does not overlap the hole transfer region (HTR),
wherein the hole transfer region (HTR) is directly on the first electrode (LE1, LE2, LE3) in the display region (DA) and is directly on the base substrate (BS) in the margin region (MA).
